# EUROPEAN PATENT APPLICATION

(11) **EP 2 485 242 A1**
(43) Date of publication of application: **08.08.2012**
(21) Application number: 12153870.6
(22) Date of filing: 03.02.2012
(51) Int. Cl.: H01J 37/34, H01J 37/32

(54) **Filter for arc source**

(30) Priority: 03.02.2011 US 201113020290
(71) Applicant: Vapor Technologies, Inc., Longmont CO 80503 (US)
(72) Inventor: Brondum, Klaus, Longmont, CO 80504 (US)
(74) Representative: Croston, David

(57) **Abstract**

An arc source filter is disposed between an arc cathode and a substrate in a vacuum arc deposition system. The filter includes a plurality of duct elements that surround the arc source. The duct elements have sufficient spatial dimensions to block particles. In addition, the duct elements have electrical and magnetic properties that are conducive for plasma transmission through the filter. On passing through the filter, the highly ionized arc plasma is essentially rid of particles making a source plasma for reacted as well as un-reacted coatings characterized by high density and near defect free quality. The design allows for flexibility in terms of filtering degree, length of coating zone as well as choice of arc source.

## Description

### BACKGROUND

### 1. Field of the Invention

The present invention relates to arc deposition systems and, in particular, to methods of filtering particles from such arc deposition systems.

### 2. Background Art

Over the last 20 years, cathodic arc deposition has become established as a reliable source of highly ionized plasma for deposition of reacted as well as un-reacted coatings from conductive target materials such as zirconium, titanium, chrome, aluminum, copper and alloys thereof. The highly ionized plasma and the associated electron beam generated in the arc evaporation process is also used in such surface processing techniques as ion sputtering, etching, implantation and diffusion processes.

An undesirable side effect of the arc evaporation process is the generation of macroscopically large particles ("macro-particles")which tend to end up on substrates to be treated. These macro-particles potentially represent defects in the developing film, loosely adherent impurities, surface in homogeneity and add roughness to the surface. The presence of macro-particles reduces the value and general applicability of the coating in demanding applications requiring superior properties such as corrosion performance, homogeneity, hardness, gloss or barrier performance.

Filters that can lower macro content reaching the substrate from arc evaporated plasmas are known. Such prior art filters typically rely on the following mechanisms. Some filters provide a physical barrier that intercepts macro-particles as they propagate in line of sight from an arc spot on the cathode towards the substrate. Such barriers may be associated with features that partially prevent bouncing macro-particles from reaching the substrate. Other prior art filters use a shaped magnetic field that steers the arc electron beam in a trajectory clear of the physical barrier and a strength at least partially magnetically insulating the physical barrier from being an anode for the electrons. Finally, some prior art filters use a positive potential of the physical barrier repelling ions present in the arc generated plasma. Filters relying on a combination of these three filter principles are described in the scientific and patent literature. For an overview see Anders, A., "Approaches to rid cathodic arc plasmas of macro- and nano particles - a review, "SURFACE AND COATINGS TECHNOLOGY, volume 120, 1999, pages 319-330.

Cathodes for filtered arc sources are typically point source, i.e. circular cathodes, while a few elongate configurations such as linear aligned multiple point sources and linear sources have been described. The linear arrangement of the arc source allows for elongated coating zones and greatly increases the large volume production potential of the filtered arc technology. Yet, cylindrical target filtered arc plasma sources are even more desirable for coating or ion processing of large substrates, sheet material in roll form, and for quantities of smaller substrates on a linear conveyor or circular carousel.

Although the prior art methods for filtering macro-particles from arc deposition processes work reasonably well, these methods still suffer from a number of drawbacks. For example, deposition systems using the prior art filters tend to have a low net ion output current from the cathode target. The prior art methods also tend to have suboptimal utilization of the cathode surface. Finally, the coatings formed in such methods still tend to include an undesirable level of defects.

Accordingly, there is a need for improved cathode arc deposition systems with improved macro-particle filtering.

### SUMMARY

The present invention solves one or more problems of the prior art by providing, in at least one embodiment, a filter for an arc deposition system which includes an elongated cathode, an anode, and at least one substrate. The filter includes an even number of duct assemblies symmetrically positioned around the elongated cathode. The duct assemblies define a magnetic field for guiding a plasma and have a baffle component for blocking macro-particles.

In another embodiment, a filter assembly for use in an arc deposition system is provided. The filter assembly includes an even number of duct assemblies symmetrically positioned around the cathode target. The duct assemblies define paths through which positively charged ions are guided from a cathode target to a substrate. In order to accomplish such guidance, the duct assemblies are electrically biased such that positively charged ions are repelled. The duct assemblies also include components for generating a magnetic field that guide a plasma from the cathode target to the substrates. In particular, the magnetic field guides the movement of electrons which desirably results in ions (i.e., positively charged) moving in a manner to avoid collision with the filter. The duct assemblies also include baffles for blocking macro-particles from reaching substrates. Neutral and negatively charged particles are undesirable as they lead to imperfections and agglomerates in the coating. The neutral and negatively charged particles collide with the filter and are, therefore, removed and prevented from reaching the substrate.

In still another embodiment, an arc deposition system for removing material from a cathode target which is deposited on a substrate is provided. The arc deposition system includes an elongated cathode target which is placed within a vacuum chamber. One or more substrates are positioned within a substrate zone that is a predetermined distance from the cathode target in the vacuum chamber. The filter assembly is also placed within the vacuum chamber such that the filter assembly is interposed between the cathode target and the substrate zone. Characteristically, the filter assembly includes an even number of duct assemblies symmetrically positioned around the cathode target. The duct assemblies define paths through which positively charged ions are guided from the cathode target to the substrates. In order to accomplish such guidance, the duct assemblies are electrically biased such that positively charged ions are repelled. The duct assemblies also include components for generating a magnetic field that guides a plasma from the cathode target to the substrates. The magnetic field guides the movement of electrons which desirably results in ions (i.e., positively charged) moving in a manner to avoid collision with the filter. The duct assemblies also include baffles for blocking macro-particles from reaching substrates. Neutrals and negatively charged particles are undesirable as they lead to imperfections and agglomerates in the coating. The neutral and negatively charged particles collide with the filter and are, therefore, removed and prevented from reaching the substrate.

### BRIEF DESCRIPTION OF THE DRAWINGS

Exemplary embodiments of the present invention will become more fully understood from the detailed description and the accompanying drawings, wherein:

FIGURE 1A is a schematic of an arc deposition system incorporating a filter;

FIGURE 1B is a schematic cross section of the deposition chamber and components therein of an arc deposition;

FIGURE 2 is a top view of illustrating the positioning of the duct elements about a cathode target;

FIGURE 3 is a perspective view of a filter to be placed around a cathode in an arc deposition system;

FIGURE 4 is a perspective view of a filter to be placed around a cathode mounted on a vacuum flange;

FIGURE 5 provides an electromagnetic contour plot of filter when operated in ion transmission mode for a chromium cathode using a filter in accordance to Figures 1-4;

FIGURE 6 provides magnetic flux density at a cross section through a filtered cylindrical cathode arc plasma source as depicted in Figure 4;

FIGURE 7A is an optical micrograph at 200x magnification of a Cr coating without filtering;

FIGURE 7B is an optical micrograph at 200x magnification of a Cr coating with filtering;

FIGURE 8 provides a plot of the frequency of particles as a function of particle size as realized from filter using chromium target; and

FIGURE 9 is a plot of relative horizontal angular distribution of deposit output from one of the four filter ports as realized with a chromium target

### DETAILED DESCRIPTION

Reference will now be made in detail to presently preferred compositions, embodiments and methods of the present invention, which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

Except in the examples, or where otherwise expressly indicated, all numerical quantities in this description indicating amounts of material or conditions of reaction and/or use are to be understood as modified by the word "about" in describing the broadest scope of the invention. Practice within the numerical limits stated is generally preferred. Also, unless expressly stated to the contrary: percent, "parts of," and ratio values are by weight; the description of a group or class of materials as suitable or preferred for a given purpose in connection with the invention implies that mixtures of any two or more of the members of the group or class are equally suitable or preferred; description of constituents in chemical terms refers to the constituents at the time of addition to any combination specified in the description, and does not necessarily preclude chemical interactions among the constituents of a mixture once mixed; the first definition of an acronym or other abbreviation applies to all subsequent uses herein of the same abbreviation and applies mutatis mutandis to normal grammatical variations of the initially defined abbreviation; and, unless expressly stated to the contrary, measurement of a property is determined by the same technique as previously or later referenced for the same property.

It is also to be understood that this invention is not limited to the specific embodiments and methods described below, as specific components and/or conditions may, of course, vary. Furthermore, the terminology used herein is used only for the purpose of describing particular embodiments of the present invention and is not intended to be limiting in any way.

It must also be noted that, as used in the specification and the appended claims, the singular form "a," "an," and "the" comprise plural referents unless the context clearly indicates otherwise. For example, reference to a component in the singular is intended to comprise a plurality of components.

Throughout this application where publications are referenced, the disclosures of these publications in their entireties are hereby incorporated by reference into this application to more fully describe the state of the art to which this invention pertains.

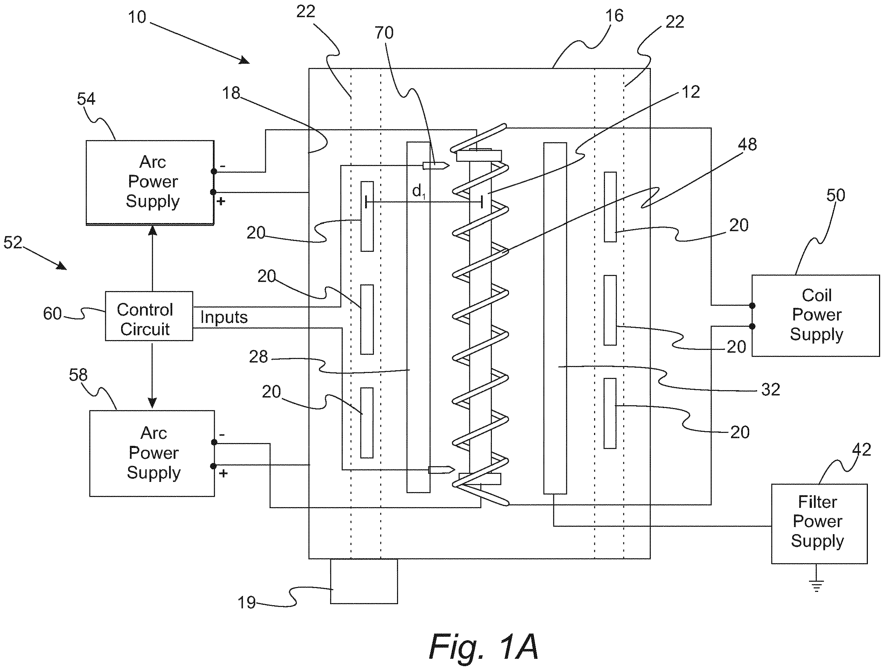

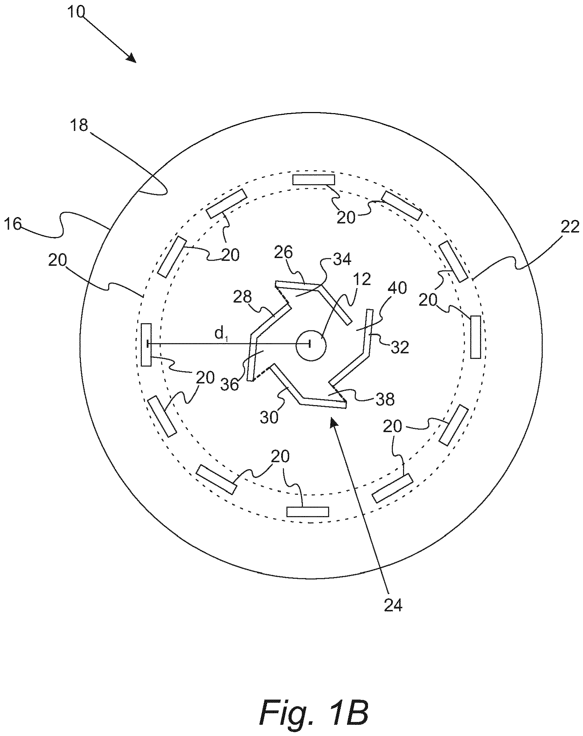

With reference to Figures 1A and 1B, schematic illustrations of an arc deposition system incorporating a filter are provided. The arc deposition of this embodiment is an advance over the systems set forth in U.S. Pat. No. 5,269,898, the entire disclosure of which is incorporated by reference. In particular, the present embodiment provides a system in which a filter capable of significantly reducing the spoilage of a coating with macro-particles is adapted to the system of U.S. Pat No. 5,269,898. Figure 1A is a schematic of an arc deposition system incorporating a filter. Figure 1B is a schematic cross section of the deposition chamber and components therein of an arc deposition. During operation of the arc deposition systems set forth above, an arc is struck which causes significant ionization of gas and cathode atoms thereby forming a plasma. The ionized metal cathode ions are directed from the region of the cathode towards the substrates which are coated with a metal layer. Arc deposition system 10 includes cathode target 12 which is placed within vacuum chamber 16. Arc deposition system 10 includes at least one anode. In a refinement, wall 18 of vacuum chamber 16 is an anode. Characteristically, cathode target 12 is of an elongated design (e.g., cylindrical or rod-shaped). It should also be appreciated that the cross section of target 12 may be of virtually any shape, examples of which include, but are not limit to circular, triangular, square, pentagonal, hexagonal, elliptical or irregularly shaped. Arc deposition system 10 is maintained at a reduced pressure during coating of a substrate via suitable vacuum systems as is known in the field via port 19. Typically, operating pressures are between 0.5 and 50 mT. It should be noted that fully reacted coatings can be realized above approximately 1mT using (e.g., chromium target in mixed argon nitrogen atmosphere.)

Although the present embodiment is not limited by the dimensions of cathode target 12, typically cathode 12 has a diameter from 1 to 10 inches and a length from 6 inches to 5 feet. Substrates 20 are positioned within substrate zone 22 that is a distance d₁ from cathode target 12. Filter assembly 24 is also placed with vacuum chamber 16. In particular, filter assembly 24 is interposed between cathode target 12 and substrate zone 22. Filter assembly 24 includes an even number of duct assemblies 26, 28, 30, 32 symmetrically positioned around cathode target 12. Duct assemblies 26, 28, 30, 32define ducts 34, 36, 38, 40through which positively charged ions are guided from cathode target 12 to substrates 20. In order to accomplish such guidance, duct assemblies 26, 28, 30, 32are electrically biased such that positively charged ions are repelled from the duct assemblies via filter power supply 42. A voltage of plus 10 volts or more effectively repels positively charged ions. Duct assemblies 24, 26, 28, 30also include components for generating a magnetic field that guides a plasma (i.e., positively charged ions) from cathode target 12 to substrates 20. In a refinement, duct assemblies 24, 26, 28, 30also include baffles for blocking macro-particles from reaching substrates 20.

In a refinement, system 10 includes helical electromagnet coil 48which is coaxially mounted about cathode target 12. Helical electromagnet coil 48 is powered by a separate coil power supply 50. Electromagnet coil 48 may be electrically isolated or it may be connected to the vacuum chamber 16.

Control system 52 is provided to vary the current input to each end of the cathode target 12 while maintaining the total arc current substantially constant, such that the current to each end of cathode target 12 may be varied between 0 and 100 percent of the total arc current supplied. Arc current is directly correlated to deposition rate and can be controlled between 50A and, for example, 2000 A, the upper limit determined by cooling efficiency of target. This may be accomplished by using separate arc power supplies 54, 56 connected at each end of cathode target 12 with a controller 58 to provide complementary set point signals for the separate arc power supplies 54, 56. In an alternative variation, a single arc power supply having two complementary current outputs may be employed.

Still referring to Figures 1A and 1B, the arc tends to be drawn toward whichever end of the cathode target 12 is receiving the larger fraction of the total current input, due to the self magnetic field of the arc current in the cathode target. The speed at which the arc moves in one direction along the cathode target 12 is partly determined by the degree of imbalance between the currents flowing into each end of cathode target 12. The arc spot can, therefore, be scanned back and forth along the cathode target 12 by varying the division of current between the two ends of cathode target 12 in an oscillatory fashion. Cathode target 12 can, therefore, be uniformly eroded, and the arc can be maintained continuously on the cathode surface rather than being repeatedly restruck as taught by the prior art. A sensor may be conveniently located at each of the ends of the evaporable surface of cathode target 12 to provide a signal when the arc spot reaches one end of the evaporable surface of cathode target 12, at which time the current division may be reversed, allowing automated scanning of the arc spot along the entire surface of cathode target 12.

Electromagnet coil 48 may be connected in series with the arc power supply 54, 56, such that the arc current flows through electromagnet coil 48 to generate an axial magnetic field. Since the coil is connected between the positive output of arc power supply 54, 56 and the anode, and since the total arc current is constant, the current input to the electromagnet coil 48 is not affected by the variation in current to the two ends of cathode target 12. This arrangement eliminates the necessity of a separate power supply for powering electromagnet coil 48, but sacrifices independent adjustability of the strength of the applied magnetic field except through selection of the pitch of electromagnet coil 48.

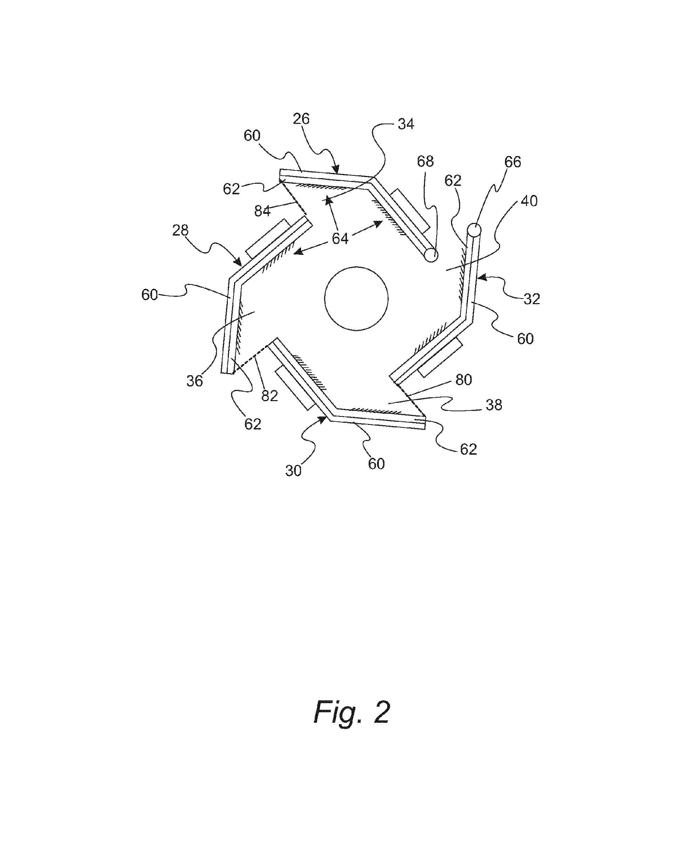

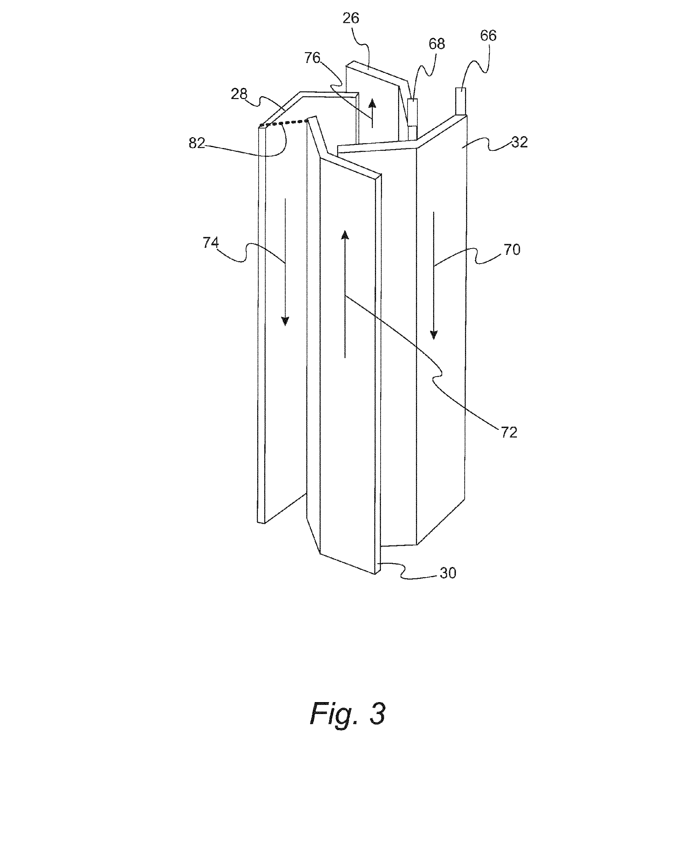

With reference to Figures 2 and 3,a filter for an arc deposition system is provided. The filter of the present embodiment is positionable between the cathode and the substrates of the arc deposition system. Filter assembly 24 includes an even number of duct assemblies symmetrically positioned around elongated cathode12. The variation set forth in Figures 2 and 3 includes four duct assemblies, i.e., duct assemblies 26, 28, 30, 32. Duct assemblies 26, 28, 30, 32define ducts 34, 36, 38, 40through which positively charged ions are guided from cathode target 12 to substrates 20. Duct assemblies 26, 28, 30, 32 define a magnetic field for guiding a plasma. Duct assemblies 26, 28, 30, 32 each include support component 60 and baffle component 62 for blocking macro-particles. In a refinement, baffle component 62 includes protrusions 64 for enhancing the ability of filtering out macro-particles. Electrical posts 66, 68 are used to connect to the filter power supply so that the duct assemblies are electrically biased for repelling positively charged ions. In such situations, baffle component(s) have an electrically positively charged surface.

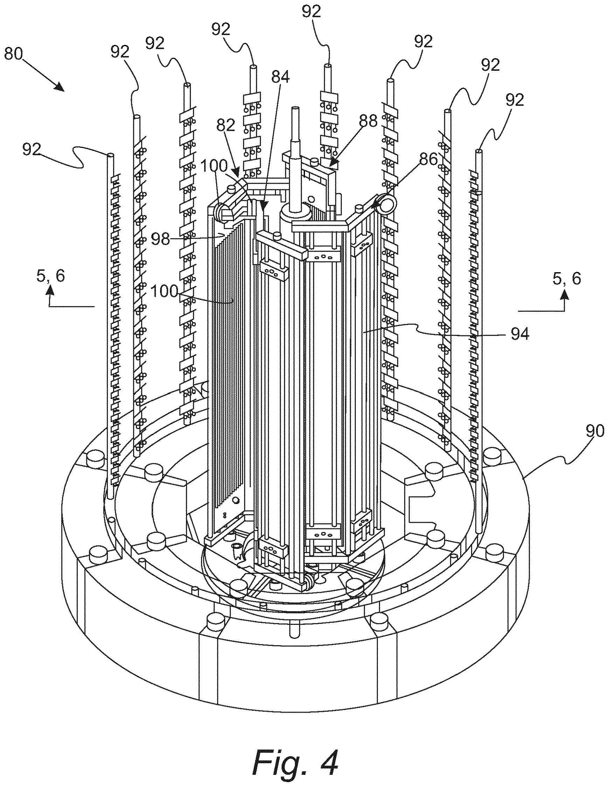

With reference to Figure 4, a schematic perspective view of a filter assembly with peripheral substrate holders is provided. Filter assembly 80 includes duct assemblies 82, 84, 86, 88 which are mounted on vacuum flange 90. Filter assembly 80 also includes sample holders 92 onto which samples to be coated are mounted. Note that in Figure 4, several sample holders are removed to allow viewing of the duct assemblies. In general, sample holders 92 are distributed in a circle about the duct assemblies. Each of duct assemblies 82, 84, 86, 88 independently include structural component 94 which is formed from metal tubing. As set forth above, a current is passed through structural component(s) 94 to establish a magnetic field. Duct assemblies 82, 84, 86, 88 also independently include baffle component 98 for blocking macro-particles with protrusions 100 disposed thereon. Moreover, duct assemblies 82, 84, 86, 88 are linked together as set forth above via junctions 100.

It should be appreciated that dimensions and orientation of duct assemblies depicted above as well as characteristics of magnetic field elements the transmission and filter efficiency can be altered without departing from the underlying teaching of this invention. Filters allowing a tailoring of the amount of macro-particle content in the coatings are achievable.

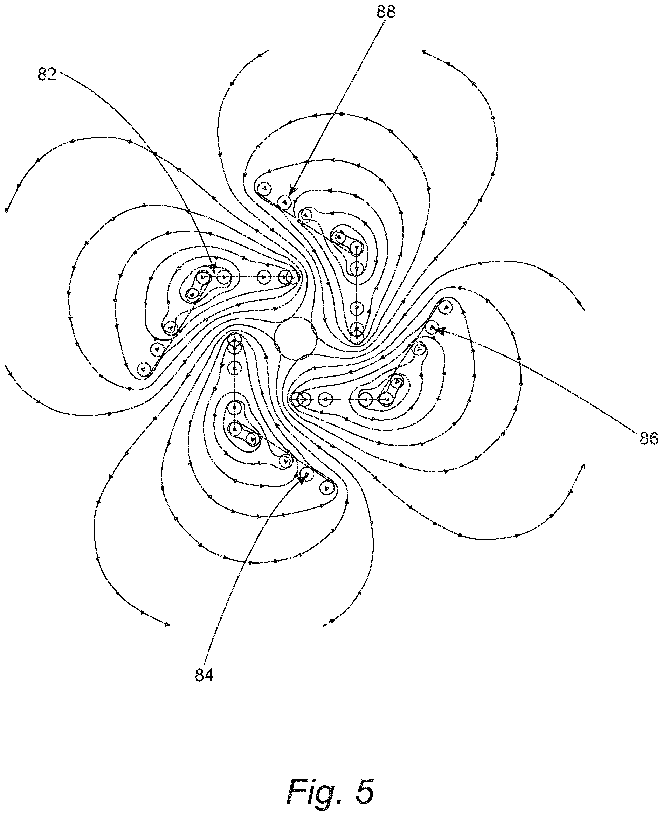

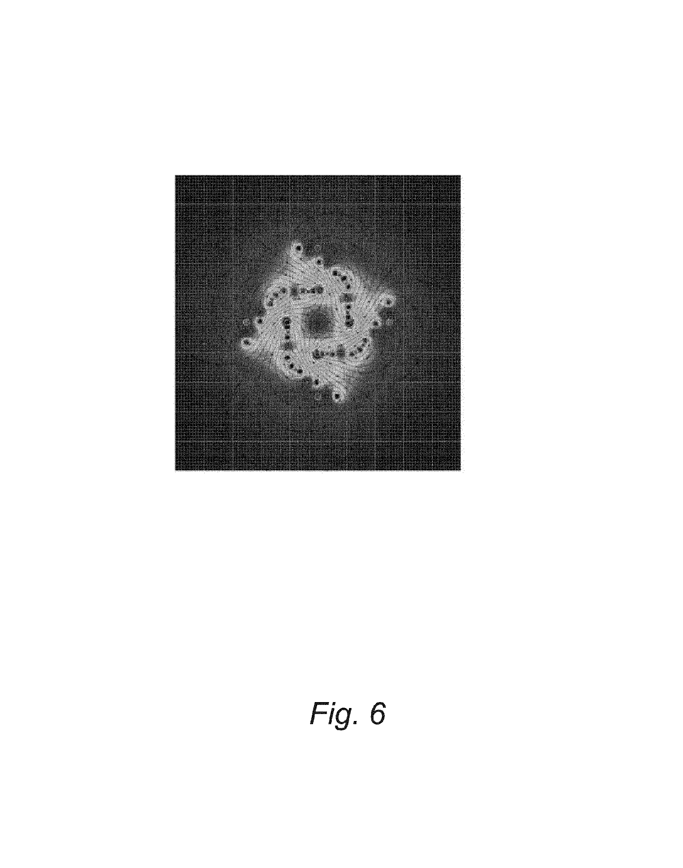

With reference to Figures 2, 3, 4,5, and 6 a magnetic field is optionally created by passing a current through the duct assemblies so as to create a magnetic field. In particular, adjacent duct assemblies generate magnetic fields with opposite magnetic polarities. Arrows 70, 72, 74, 76 indicate an example of the directions that current may flow to create such magnetic field. To accomplish this alteration, the duct assemblies are electrically connected as shown by links 80, 82, 84 in a staggered manner at the top or bottom. The magnetic field generated in this manner has an orientation normal to an elongated cylindrical cathode surface and strength conducive to plasma guidance produced by passing current through the duct assemblies. Sufficient field strength for plasma guidance is design dependent. For the example,a useful range is provided between 6,000 and 12,000 ampere-turns. The lower limit is defined by target ion transmission, while the upper limit is defined by electron scattering phenomenon (magnetic electron mirror) blocking target ion transmission. Figure 5 provides a cross section of the magnetic field contour line for a filter having four duct assemblies as depicted in Figure 4. The positions of duct assemblies 82, 84, 86, 88 in relation to the contour lines are shown in this figure. Similarly, Figure 6 provides magnetic flux density at a cross section through a filtered cylindrical cathode arc plasma source. It should be noted that duct assemblies 82, 84, 86, 88 may be biased (positively charge) as well as carrying a current to generate the requisite magnetic fields. In a variation, the structural component carries the current while the baffle component is biased. In this variation, structural and baffle components are electrically isolated. In another variation, the structural and baffle components are not electrically isolated.

As set forth above, the filter of the present embodiment includes an even number of duct assemblies that are symmetrically placed around cathode target 12. In a refinement, the number of duct assemblies is an even number from 2 to 8. In another refinement, the number of duct assemblies is an even number from 4 to 8. The inclusion of four duct assemblies is found to be particularly useful. Moreover, as depicted in Figures 1A and 2, baffle component 62is positioned on a side of the duct assembly facing cathode target 12 such that a line of sight between the cathode and substrate zone is blocked.

With reference to Figures 1A and 1B, the arc deposition system may be operated as an electron beam system. During such operations, the filter may be operated without baffle bias. In this scenario, the magnetic field strengths may also be low. The operation of the filter in electron beam mode may aid in substrate cleaning and requires that the substrate is biased positively. The electron beam may also be used in aiding electron beam evaporation such as the deposition of aluminum using a secondary target source.

Still referring to Figures 1A and 1B, the arc deposition system may be operated as an ion beam system. During such operations, the pressures in the deposition chamber are at or above 1 mT and the filter is without baffle bias. In this scenario, escaping electrons ionize gas molecules which escape through the filter exits. The operation of a filter in ion beam mode may aid cleaning of substrate and requires that substrate is biased negative. Extended substrate treatment with ion beam may, at elevated temperature, facilitate nitriding of steel substrate (nitrogen containing plasma)and carburizing of steel (carbon containing plasma).

It should further be apparent that alternative cathode configurations can be operated in the filter configuration of this invention. One such cathode configuration well known in the art, is the rotary cylindrical cathode described, for example, in US Patent 6,262,539 (the entire disclosure of which is incorporated herein by reference) which can be operated in present filter invention without departing from the scope and teachings of this invention. Another cathode configuration well known in the art, is the planar magnetron as described, for example, in US Patent 4,892,633 (the entire disclosure of which is incorporated herein by reference) which can be operated in present filter invention without departing from the scope and teachings of this invention.

The following examples illustrate the various embodiments of the present invention. Those skilled in the art will recognize many variations that are within the spirit of the present invention and scope of the claims.

A filtered arc as disclosed with four duct elements was furnished with a chromium cylindrical cathode. The chamber was pumped down to 1 mTorr and maintained at pressure using argon as background gas. An arc was stricken and maintained at 900A while passing 8000 A through duct elements biased at plus 30 volts, passing 100 A through steering coil and biasing the substrate at minus 50 volts. A current of 40A was collected at the substrate and a Cr film deposited. The deposited film was documented for macros showing a reduction in macro content from 1% volume to less than 0.01% volume as compared to an unfiltered arc. The cross sectioned Cr film showed generally amorphous and isotropic properties without signs of defects.

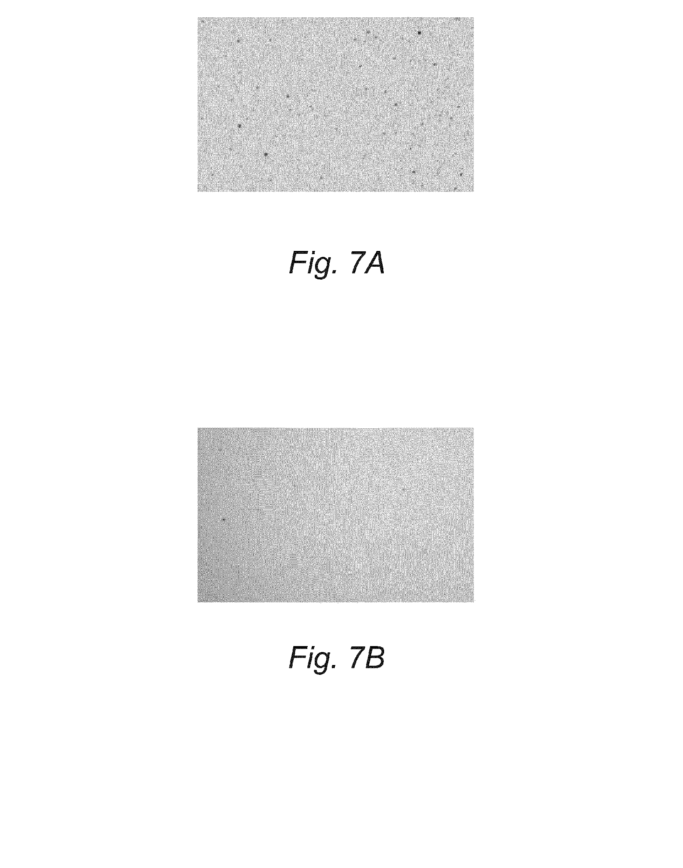

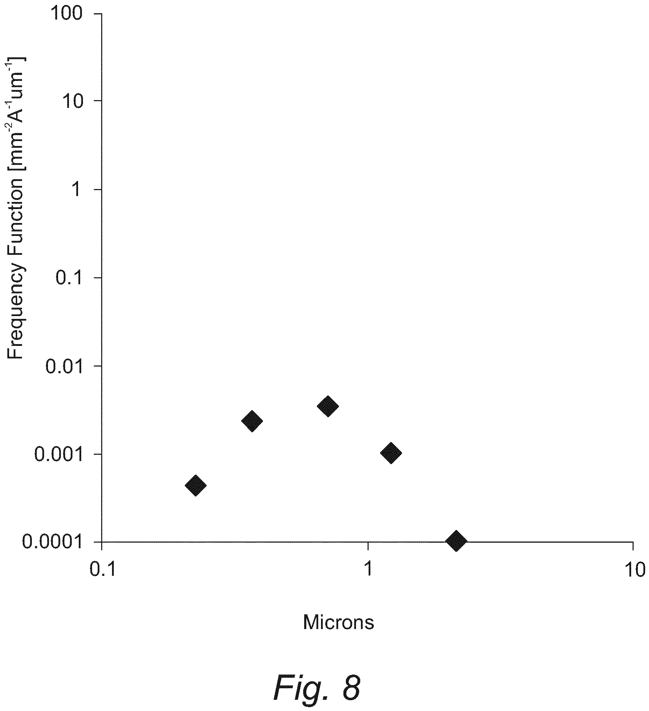

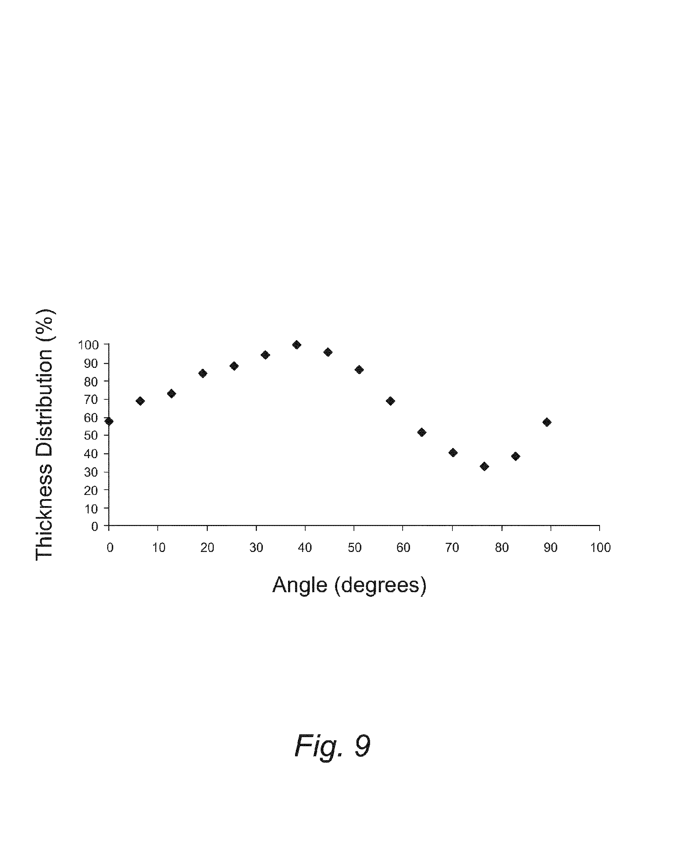

Figures 7A and 7B provide a comparison of macro-particle content in a Cr coating obtained with filtering and without filtering as set forth above. Figure 7A is a scanning electron micrograph of a Cr coating without filtering while Figure 7B is a scanning electron micrograph of a Cr coating with filtering. It is readily observable that the coating with filter has significantly fewer macro-particles included therein. Figure 8 provides a plot of the frequency of particles as a function of particle size. This figure shows a very low distribution of particles of size about 1 micron. It should be noted that macro frequency density is underestimated for macro diameters under 0.5 microns due to resolution limitations of optical micrography used for macro documentation. Figure 9 provides the relative (%) thickness variation for coating deposited on substrates in the substrate zone as of function of angle of placement (0-90 degrees) with respect to a plane oriented through the cathode target along the long direction. Only zero to 90 degrees are documented due to symmetry.

A filtered arc as disclosed with four duct elements was furnished with a chromium cylindrical cathode. The chamber was pumped down to 1 mTorr and maintained at pressure using argon and nitrogen in 1:1 ratio as background gas. An arc was stricken and maintained at 900A while passing 8000 A through duct elements biased at plus 30 volts, passing 100 A through steering coil and biasing the substrate at minus 50 volts. A current of 40A was collected at the substrate and a Cr film deposited. The deposited film was documented for macros showing a reduction in macro content from 1% volume to less than 0.01% volume as compared to an unfiltered arc. The cross sectioned CrN film showed generally amorphous and isotropic properties without signs of defects.

While embodiments of the invention have been illustrated and described, it is not intended that these embodiments illustrate and describe all possible forms of the invention. Rather, the words used in the specification are words of description rather than limitation, and it is understood that various changes may be made without departing from the scope of the invention.

## Claims

1. A filter for an arc deposition system where the arc deposition system comprises an elongated cathode, an anode, and at least one substrate, the filter comprising:
an even number of duct assemblies symmetrically positioned around the elongated cathode, the duct assemblies defining a magnetic field for guiding a plasma and having a baffle component for blocking macro-particles.

2. The filter of claim 1 wherein the duct assemblies also define an electrical bias for repelling positively charged ions and the baffle component has an electrically positively charged surface.

3. The filter of claim 1 or 2 wherein the duct assemblies are electrically biased for repelling positively charged ions.

4. The filter of claim 1 or 2 wherein the filter is positionable between the cathode and the substrate.

5. The filter of claim 1 or 2 wherein adjacent duct assemblies have opposite magnetic polarities.

6. The filter of claim 1 or 2 wherein the number of duct assemblies is an even number from 2 to 8.

7. The filter of claim 1 wherein the number of duct assemblies is four.

8. The filter of claim 1 or 2 wherein the baffle component is positioned on a side of the duct assembly facing the cathode such that a line of sight between the cathode and substrate zone is blocked.

9. The filter of claim 1 wherein the baffle component has an electrically positively charged surface.

10. The filter of claim 1 or 2 wherein duct assemblies are surrounded by a magnetic field having an orientation normal to an elongated cylindrical cathode surface and a strength conducive to plasma guidance produced by passing current through the duct assemblies.

11. An arc deposition system comprising:
an elongated cathode;
a substrate zone having a plurality of substrates disposed around the arc cathode;
an anode located distally from the elongated arc cathode;
a negatively biased substrate zone; and
a filter disposed between the cathode and the substrates, the filter having the features of any of claims 2, 4 to 6, 8 or 10.

12. The arc deposition system of claim 11 wherein the baffle component has an electrically positively charged surface.

13. The arc deposition system of claim 11 further comprising a plurality of permanent magnets to modify the magnetic field.

14. The arc deposition system of claim 11 wherein the magnetic field has a variable magnitude between 0 and 200 Gauss at an arc cathode surface, the magnetic field changing towards a variable minimum of magnitude of zero-1000 Gauss a predefined distance from the arc cathode surface and tapering off proceeding towards the substrate zone.

15. The arc deposition system of claim 11 wherein the filter is operated without baffle bias at low magnetic field strength at pressures below 1mT such that electrons escape through filter exits converting the arc deposition system to an electron beam system.

16. The arc deposition system of claim 11 wherein the filter is operated at low magnetic field strength at or above a pressure of 1 mT such that escaping arc electrons ionize gas molecules that escape through filter exits converting the arc deposition system to an ion beam system.
